# EUROPEAN PATENT APPLICATION

(11) **EP 3 851 501 A1**
(43) Date of publication of application: **21.07.2021**
(21) Application number: 19860573.5
(22) Date of filing: 13.09.2019
(51) Int. Cl.: C09D 11/52, G01B 7/16, H05K 1/09

(54) **ELECTROCONDUCTIVE INK AND CARBON WIRING SUBSTRATE**

(30) Priority: 13.09.2018 JP 2018171414; 13.09.2018 JP 2018171415
(71) Applicant: Osaka University, Suita-shi, Osaka 565-0871 (JP); Showa Denko K.K., Tokyo 105-8518 (JP)
(72) Inventor: ARAKI, Teppei, Suita-shi, Osaka 565-0871 (JP); SEKITANI, Tsuyoshi, Suita-shi, Osaka 565-0871 (JP); KUWAHARA, Jun, Tokyo 105-8518 (JP); ISHII, Nobuaki, Tokyo 105-8518 (JP); OHATA, Hideki, Tokyo 105-8518 (JP)
(74) Representative: Strehl Schübel-Hopf & Partner
(86) International application number: PCT/JP2019/036084
(87) International publication number: WO 2020/054844

(57) **Abstract**

[Problem] To provide an electroconductive ink suitable for an inexpensive carbon wiring substrate having a wide strain sensing range, and a carbon wiring substrate in which the electroconductive ink is used.

[Solution] An electroconductive ink characterized by including a carbonaceous electroconductive material (A), a binder resin (B) including a cellulose compound (B1) and a poly N-vinyl compound (B2), and a solvent (C), the electroconductive ink including 0.5-23 parts by mass of the binder resin (B) with respect to 100 parts by mass of the carbonaceous electroconductive material (A), the mass blending ratio of the cellulose compound (B1) and the poly N-vinyl compound (B2) being 80:20 to 40:60, and the solvent (C) including water (C1). A carbon wiring substrate having a wiring pattern formed using the electroconductive ink.

## Description

### Technical Field

The present disclosure relates to an electroconductive ink suitable for forming a resistance film of a resistive strain sensor, and a carbon wiring substrate using the same.

### Background Art

It is known that a mechanical sensor such as a pressure sensor, an acceleration sensor, etc., uses a strain sensor element (strain gauge) for detecting a deformation amount of an object to be measured. The strain sensor element provided with a strain resistant thin film which deforms corresponding to the strain of the object to be measured, can measure a deformation amount of the object to be measured by measuring the electric resistance of the strain resistant thin film

As a resistive strain sensor element, a foil gauge, a semiconductor sensor, an optical fiber sensor are well known. However, they are disadvantageous in cost, etc., when used for a large area structure. A strain gauge for concrete using a thin metal foil for a sensor part has only a narrow strain sensing range because the thin metal foil is easily broken, and thus, sensible strain is up to approximately 2%, only. Whereas, a pie gauge can sense a large strain, but requires a special installation method, and is inferior for application to a large area and constant observation.

On the other hand, an organic printed resistance body is widely known as a resistance body which can be formed at a low cost (for example, refer to Japanese Unexamined Patent Publication (Kokai) No. 59-22387 (Patent Document 1)). When this is used for the strain sensor, the gauge rate is small, and variation in resistance values depending on humidity/temperature is large, which are drawbacks in usage as a strain gauge.

Further, in a known organic printed resistance body, when a thermosetting resin is used (for example, refer to Japanese Unexamined Patent Publication (Kokai) No. 7-243805 (Patent Document2)), sensing of large strain is not possible because, in general, a thermosetting resin is hard and brittle. Whereas, a soft resin, such as rubber, etc., is not suitable for sensing static strain because the creep is large. A known carbon wiring substrate is usually resin-rich and has no voids, and thus, the strain sensing range is assumed to be narrow.

### Prior Arts

### Patent Document

Patent Document 1: Japanese Unexamined Patent Publication (Kokai) No.59-22387
Patent Document 2: Japanese Unexamined Patent Publication (Kokai) No.7-243805

### Summary

One of the objectives of the present disclosure is to provide an electroconductive ink suitable for an inexpensive carbon wiring substrate having a wide strain sensing range, and a carbon wiring substrate using the same.

As result of diligent examination to obtain a printed resistance body having a high environment resistance and a wide strain sensing range, the inventors have conceived of the present disclosure. Namely, the present disclosure includes the following aspects.
[1] An electroconductive ink comprising: a carbonaceous electroconductive material (A), a binder resin (B) containing a cellulose compound (B1) and a poly N-vinyl compound (B2), and a solvent (C), wherein a content of binder resin (B) is 0.5 to 23 parts by mass relative to 100 parts by mass of (A) carbonaceous electroconductive material, a mixing ratio by mass of the cellulose compound (B1) and the poly N-vinyl compound (B2) is 80:20 to 40:60, and the solvent (C) contains water (C1).
[2] An electroconductive ink according to [1], wherein cellulose compound (B1) is sodium carboxymethyl cellulose, and the poly N-vinyl compound (B2) is poly N-vinylacetamide.
[3] An electroconductive ink according to [1] or [2], wherein the carbonaceous electroconductive material (A) is graphite powder having an average particle diameter of 25 µm or less.
[4] A carbon wiring substrate comprising an insulated substrate having thereon a wiring pattern printed by using an electroconductive ink, the electroconductive ink comprising a carbonaceous electroconductive material (A), a binder resin (B) containing a cellulose compound (B1) and a poly N-vinyl compound (B2), and a solvent (C), a content of binder resin (B) being 0.5 to 23 parts by mass relative to 100 parts by mass of (A) carbonaceous electroconductive material, a mixing ratio by mass of the cellulose compound (B1) and the poly N-vinyl compound (B2) being 80:20 to 40:60, and the solvent (C) containing water (C1).
[5] A carbon wiring substrate with a wiring pattern which comprises a carbonaceous electroconductive material (A), and a binder resin (B) containing a cellulose compound (B1) and a poly N-vinyl compound (B2), wherein a content of binder resin (B) is 0.5 to 23 parts by mass relative to 100 parts by mass of (A) carbonaceous electroconductive material, and a mixing ratio by mass of the cellulose compound (B1) and the poly N-vinyl compound (B2) is 80:20 to 40:60.
[6] A carbon wiring substrate according to [4] or [5], wherein the wiring pattern is covered with a resin film.
[7] A carbon wiring substrate according to [6], wherein the resin film comprises a silica film.

With the electroconductive ink according to the present disclosure, an inexpensive carbon wiring substrate having a wide strain sensing range, can be produced. The use of this carbon wiring substrate as a strain sensor shows an effect in measurement of infrastructure constructions, such as concrete constructions, which requires measurement of large areas. In the present specification the "wide" strain sensing range refers to the range of 0 to 10%.

### Brief Description of Drawings

FIG. 1 illustrates wiring patterns of carbon wiring substrates according to Examples and Comparative Examples.
FIG. 2 illustrates a result of strain sensitivity measurement (time-dependent change of resistance and strain) when 1% strain is applied to the carbon wiring substrate of Example 1.
FIG. 3 illustrates a result of strain sensitivity measurement (time-dependent change of resistance at each number of repeats) when 1% strain is applied to the carbon wiring substrate of Example 1.
FIG. 4 illustrates a structure of the strain sensor of Example.

### Aspects of Disclosure

Hereinbelow, an aspect of the present disclosure (hereinbelow, referred to as an aspect) will be explained.

The first aspect of the present disclosure is an electroconductive ink comprising a carbonaceous electroconductive material (A), a binder resin (B) including a cellulose compound (B1) and a poly N-vinyl compound (B2), and a solvent (C), wherein 0.5 to 23 parts by mass of the binder resin (B) is contained relative to 100 parts by mass of the carbonaceous electroconductive material (A), and the mixing mass ratio between the cellulose compound (B1) and the poly N-vinyl compound (B2) is 80:20 to 40:60. Each constituting component will be explained below.

### Carbonaceous Electroconductive Material (A)

The carbonaceous electroconductive material (A) used for the electroconductive ink according to the present aspect is carbonaceous. For the carbonaceous electroconductive material, graphite powder is preferable. The graphite powder may be natural graphite powder, artificial graphite powder, kish graphite powder, but in order to obtain a stable resistance value of the wiring substrate, the artificial graphite powder is preferable. The artificial graphite powder has a stable quality because the powder is made of solid primary particles with small amount of impurities. The carbonaceous electroconductive material (A) has an average particle diameter of preferably 25 µm or less. When the average particle diameter is 25 µm or less, drawbacks such that carbon wiring formed on the insulated substrate becomes brittle, and that the printing/coating property of the electroconductive paste decreases, can be prevented. The average particle diameter is more preferably 5 to 20 µm, and still more preferably 10 to 15 µm. In the present specification, the "average particle diameter" refers to D₅₀ value (by mass) obtained by a laser diffraction and scattering method. Note that other carbon powder such as carbon black, fullerenes, carbon nanotubes, etc., may be used in combination, as far as the content thereof is 20% by mass or less, relative to the total solid content of the electroconductive ink. If fiber-like carbon, such as carbon nanotubes, is used together, the one having a fiber length of 50 µm or less is preferable, and 40 µm or less is more preferable.

### Binder Resin (B)

The binder resin (B) used in the electroconductive ink according to the present aspect should have a function to bind materials constituting the carbon wiring substrate such as the carbonaceous electroconductive material (A) which is carbonaceous, an insulated resin substrate on which a wiring patter is to be formed using the electroconductive ink, and the like, and a function to disperse the carbonaceous electroconductive material (A), and other selected materials which can be mixed in accordance with needs in the electroconductive ink uniformly and stably, and includes a cellulose compound (B1) and a poly N-vinyl compound (B2) as essential components.

Examples of the cellulose compound (B1) include: methyl cellulose, ethyl cellulose, propyl cellulose, carboxymethyl cellulose [CMC], and a metal salt thereof. Among them, carboxymethyl cellulose [CMC] and carboxymethyl cellulose sodium salt [CMCNa] are preferable.

Examples of the poly N-vinyl compound (B2) include: poly N-vinylformamide, poly N-vinylacetamide, poly N-vinylpropionamide, poly N-vinylpyrrolidone, poly N-vinylcaprolactam, and the like. For such a poly N-vinyl compound (B2), a homopolymer constituted by single type of monomer unit can be preferably used. However, a compound including another monomer unit in the amount of less than 50 mol%, preferably 30 mol% or less, more preferably 20 mol% or less, still more preferably 10 mol% or less, can be used. Among them, using a compound having a high water solubility is preferable because dispersibility of the electroconductive carbon material in the ink increases. Among these compounds, poly N-vinylacetamide is preferable.

The binder resin (B) may include other polymer such as polyacrylic acid, polyvinyl alcohol, polyvinyl acetal, sulfonate group containing water soluble polymer (polystyrene sulfonic acid, etc.), phosphate group containing water soluble polymer (polyphosphoric acid), and polymers formed by replacing a part or all of the acid group in the above polymers by salts (sodium salt, etc.), as far as these polymers have no adverse effects on the property of the binder resin.

A combination of the cellulose compound (B1) and the poly N-vinyl compound (B2) having a preferable compatibility is a mixture of a salt of carboxymethyl cellulose [CMC] (sodium carboxymethyl cellulose [CNCNa]) and poly N-vinylacetamide [PNVA].

A mixing ratio in mass between the cellulose compound (B1) and the poly N-vinyl compound (B2) is cellulose compound (B1): poly N-vinyl compound (B2) [mass ratio] being 80:20 to 40:60, preferably 70:30 to 45:55, and more preferably 60:40 to 50:50. Further, the content of the binder resin (B) of the electroconductive ink is 0.5 to 23 parts by mass, more preferably 2 to 20 parts by mass, still more preferably 5 to 20 parts by mass, and particularly preferably 10 to 20 parts by mass, relative to 100 parts by mass of the carbonaceous electroconductive material (A).

### Solvent (C)

The electroconductive ink according to the present aspect contains a carbonaceous electroconductive material (A), a binder resin (B) including a cellulose compound (B1) and a poly N-vinyl compound (B2), and in addition, a solvent (C) which dissolves the binder resin (B). The binder resin (B) is solid at an ordinary temperature. Thus, in order to be an ink, a solvent which dissolves the binder resin (B) is required. The solvent contains water (C1) as an essential component, and in addition, can contain an organic solvent (C2) in accordance with needs.

The water (C1) is a solvent for mainly for dissolving the poly N-vinyl compound (B2), and preferably the one having no metallic ions nor organic impurities. Purified water such as ionexchange water, distilled water, etc., can be preferably used. When the electroconductive ink contains 100 parts by mass or more of the water (C1) relative to 100 parts by mass of the carbonaceous electroconductive material (A), the viscosity becomes preferable for achieving a favorable printing properties.

The cellulose compound (B1) may be watersoluble (methyl cellulose, carboxymethyl cellulose [CMC], etc.), or water-insoluble (ethyl cellulose, propyl cellulose, etc.). When a water-insoluble cellulose compound is used, the organic solvent (C2) is mixed as a solvent to dissolve the water-insoluble cellulose compound, and also to improve workability of the printing using the electroconductive ink. When only water is used as a solvent in the electroconductive ink, the water is vaporized gradually during the continuous printing, which results in drawbacks that the viscosity of the electroconductive ink is increased. Therefore, as the organic solvent (C2), an organic solvent having a lower vaporization speed than water at 25°C, and soluble to water, is preferable. Examples of the organic solvent having a lower vaporization speed than water at 25°C, and soluble to water include: glycols such as ethylene glycol, propylene glycol, etc., terpineols such as α- or β-terpineol, etc., glycol ethers such as methyl carbitol, ethyl carbitol, butyl carbitol, propylene glycol monomethyl ether, propylene glycol monoethyl ether, dipropylene glycol monomethyl ether, dipropylene glycol monoethyl ether, triethylene glycol monomethyl ether, triethylene glycol monoethyl ether, etc., and acetic esters such as cellosolve acetate, ethyl cellosolve acetate, butyl cellosolve acetate, carbitol acetate, ethyl carbitol acetate, butyl carbitol acetate, propylene glycol monomethyl ether acetate, propylene glycol monoethyl ether acetate, etc. Among them, terpineols and glycol ethers are preferable because of their high boiling point, low viscosities, etc. Only one type of these organic solvents can be used by itself, of two or more type of them can be used in combination.

The mixing ratio (mass ratio) of the water (C1) and the organic solvent (C2) depends on the type of the binder resin to be dissolved therein, but in the range that (C1)/(C2) satisfies preferably 99/1 to 20/80, more preferably 98/2 to 40/60, and still more preferably 98/2 to 50/50. The mixing amount of the solvent (C) may be adjusted to obtain an appropriate viscosity, in accordance with the printing method. By way of example, in case that a screen printing is performed, the preferable viscosity of the electroconductive ink is in the range from 0.1 to 500 Pa·s.

The content of the organic solvent (C2) in the electroconductive ink is preferably 1 to 50 parts by mass relative to 100 parts by mass of the carbonaceous electroconductive material (A). This range is preferable, because in this range, drawbacks such as decrease in solubility of the binder resin (B) and an emulsifier, decrease in dispersibility of the carbonaceous electroconductive material (A), and the like, can be prevented. As far as the property of the electroconductive ink is not impaired, a nonaqueous solvent can be added. Examples of the nonaqueous solvent include: chain carbonates such as diethyl carbonate, methyl ethyl carbonate, di-n-propyl carbonate, methyl-n-propyl carbonate, ethyl-n-propyl carbonate, methyl isopropyl carbonate, ethyl-n-propyl carbonate, ethyl isopropyl carbonate, di-n-propyl carbonate, diisopropyl carbonate, 3-fluoropropyl methyl carbonate, etc., cyclic carbonates such as propylene carbonate, ethylene carbonate, butylene carbonate, 4-chloro-1,3-dioxolane-2-one, 4-fluoro-1,3-dioxolane-2-one, 4-trifluoromethyl-1,3-dioxolane-2-one, vinylene carbonate, dimethyl vinylene carbonate, etc., ketones such as N-methyl-2-pyrrolidone, etc., and aromatic hydrocarbons such as toluene, xylene, tetramethyl benzene, etc.

The electroconductive ink according to the present aspect can further contain an emulsifier (D), in accordance with purposes such as improving compatibility between the water (C1) and the organic solvent (C2) used together with the water (C1), improving uniform dispersibility of the carbonaceous electroconductive material (A) in the ink, and the like. Examples of the emulsifier (D) include: anionic emulsifiers such as alkyl benzene sulfonate, higher fatty acid salt, alkyl sulfate ester salt, alkyl sulfonate, alkyl ether sulfate, etc. Specific examples may be hydrocarbon-based emulsifier such as CH₃(CH₂)nSO₃M, CH₃(CH₂)mSO₄M, CH₃(CH₂)oCOOM, H(CH₂)pCOO(CH₂CH₂O)qH, (NaSO₃)CH((CH₂)rCH₃)((CH₂)sCH₃) (in the formulae, M represents an univalent cation; n represents an integer of 2 to 16; m represents an integer of 2 to 16; o represents an integer of 2 to 16; p represents an integer of 2 to 40; q represents an integer of 2 to 45; r+s=an integer of 10 to 20), etc. In particular, linear alkyl (C=6 to 14) benzene sulfonic acid sodium [LAS] is preferable. The content of the emulsifier (D) is preferably 0.1 to 10 parts by mass, relative to 100 parts by mass of the carbonaceous electroconductive material (A). In this range, the compatibility between the water (C1) and the organic solvent (C2) can be increased, and the decrease in water-resistance caused by the emulsifier remaining after the drying, can be prevented.

In the electroconductive ink according to the present aspect, others, such as an antiseptic agent, a leveling agent, a viscosity increasing agent, an antisettling agent, etc., can be mixed in accordance with needs, as far as there are no adverse effects on the properties of the electroconductive ink.

The electroconductive ink according to the present aspect can be prepared by uniformly mixing the above components by a mixing means such as a mortar machine, a propeller stirrer, a kneader, a roll, a pot mill, and the like. The preparation temperature is not particular limited, and thus, preparation may be performed at an ordinary temperature.

The second aspect of the present disclosure is a carbon wiring substrate comprising an insulated substrate having thereon a wiring pattern made by the electroconductive ink according to the first aspect. Here, the "wiring pattern made by the electroconductive ink" refers to a wiring pattern containing at least the carbonaceous electroconductive material (A) and the binder resin (B), after the solvent (C) is vaporized from the electroconductive ink.

A material for the insulated substrate may be a resin such as polyimide, liquid crystal polymer, polyethylene terephthalate, polyethylene naphthalate, polybenzoxazole [PBO], epoxy resin, etc. A sheet-shaped insulated resin substrate having a thickness of 10 to 500 µm is preferable. When the thickness is within this range, the workability is preferable and a strain sensing ability is also preferable.

The carbon wiring substrate of the present aspect can be produced by forming a wiring pattern of a desired shape on the insulated substrate with the electroconductive ink according to the first aspect, by applying a printing/coating method such as wet-offset printing, dry-offset printing, relief printing, waterless planographic printing, gravure printing, flexo printing, screen printing, intaglio printing, or the like. Among the above printing/coating methods, the screen printing is preferable because a predetermined pattern can be formed by an emulsion comparatively easily. After the electroconductive ink is printed or coated, the solvent contained in the electroconductive ink is volatilized (dried) at a room temperature or by heating. In case of heating, the heating temperature is preferably in the range of 30 to 180°C, more preferably 60 to 150°C, and still more preferably 90 to 120°C, although depending on the material of the insulated substrate used. In the temperature range, the wiring pattern can be formed without damaging the insulated substrate. The drying time is preferably 1 to 360 minutes, more preferably 15 to 120 minutes, and still more preferably 30 to 60 minutes.

Preferably, the wiring pattern of the carbon wiring substrate formed by the electroconductive ink according to the first aspect on the insulated substrate is covered with a resin film. In order to protect the wiring pattern, the resin film is preferably made of a material having a mechanical strength, and having a low moisture permeability (water vapor permeability). However, when only a resin film is used, the moisture permeability (barrier property) is limited. Thus, using a resin film made of the same material as the above-mentioned insulated substrate (polyimide, polyethylene terephthalate, etc.) and provided on one face thereof with a moisture resistant (barrier) layer, is more preferable. The moisture resistant (barrier) layer may be a deposited film of silica (SiO₂), aluminum, etc., an aluminum foil, and the like. Among them, a silica (SiO₂) deposited film (thickness: 1 µm or less) is preferable. The method for covering the wiring pattern with the resin film is not limited, and a commercially available laminator can be used. Further, a resin film provided with an adhesive layer (for example, a low density polyethylene (LLDPE) layer) on a main face opposite to the face where the moisture resistant (barrier) layer is provided, is preferable, the adhesive layer covering the wiring pattern and having superior adhesion to the insulated substrate. The resin film may be laminated only on a face of the carbon wiring substrate on which the wiring pattern is formed to cover the entirety of the wiring pattern. However, preferably, the resin film may be also laminated on a face of the carbon wiring substrate on which the wiring pattern is not formed, i.e., on the rear face, so that the carbon wiring substrate is held between two resin films while preventing the ends of the carbon wiring substrate from protruding.

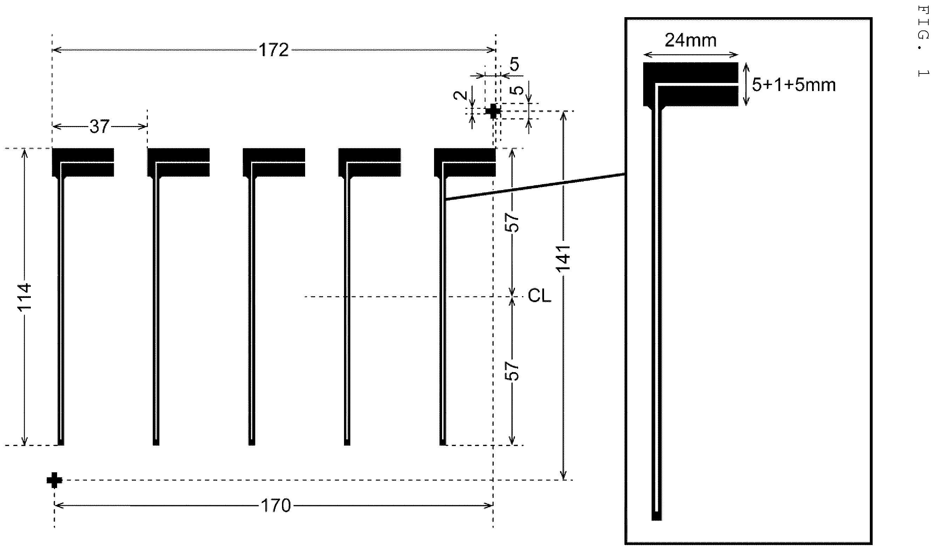

The wiring pattern of the carbon wiring substrate preferably has a linear shape with a length of 30 to 120 mm, and a width of 0.5 to 10 mm. In order to obtain a resistance value necessary for the strain measurement, the pattern may be a folded pattern as shown in FIG. 1, so that the wiring length is long and the length of the wired substrate is short.

### Example

Hereinbelow, the present disclosure will be explained in more detail with Examples and Comparative Examples, but the present disclosure is not limited to the examples below.

### <Preparation of Electroconductive Ink>

### Example 1

Based on the compositions shown in Table 1 (numerical value of each component is shown in parts by mass), 0.8 g of sodium carboxymethyl cellulose (CMCNa, n (number of repeating unit)=500, manufactured by Tokyo Chemical Industry Co., Ltd.), and 19.2 g of a solvent (main solvent: water) were provided in a predetermined container (content: 150 mL) for AWATORI RENTARO (registered trademark) ARV-310 manufactured by Thinky Corporation, and thus, a mixed and dispersed aqueous solution (resin solution) of 4% by mass was prepared. The resin solution is processed by an ultrasonic homogenizer (Sonifier (registered trademark), 250-Advanced, 200 W, manufactured by BRANSON Ultrasonics Co., Ltd.) at the output power 20% for 8 minutes to become completely resolved. Thereafter, 8 g of flake graphite powder (SCMG (registered trademark) XR-S, average particle diameter: 12 µm, manufactured by Showa Denko K.K.), and 20 g of 4%-by-mass aqueous solution of poly N-vinylacetamide (PNVA (registered trademark), GE191-053, weight-average molecular weight: 1,500,000 [catalog value], manufactured by Showa Denko K.K.) were added thereto, which was further processed by the ultrasonic homogenizer Sonifier (registered trademark), 250-Advanced, 200W, manufactured by BRANSON Ultrasonics Co., Ltd.) at the output power 50% or less for 15 minutes or more so as to be sufficiently mixed and dispersed. Thereby, 48 g of graphite dispersion paste was obtained. 0.8g of solvent (sub-solvent: terpineol, isomer mixture, manufactured by FUJIFILM Wako Pure Chemical Corporation), and 0.3 g of emulsifier (LAS (sodium linear alkyl (C=6 to 14) benzene sulfonate) [manufactured by FUJIFILM Wako Pure Chemical Corporation] prepared to aqueous solution or 1% by mass) were added to the obtained paste. The resultant was mixed (coarse mixed) to become almost uniform using a rotational stirrer (Homogenizing Disper Model 2.5, manufactured by PRIMIX Corporation) at 1000 rpm, for approximately 2 minutes, and thereafter, uniformly mixed using AWATORI RENTARO (registered trademark) manufactured by Thinky Corporation at 1200 rpm, for 3 minutes, and thereafter, at 2000 rpm for 5 minutes. Then, the resultant was condensed until the viscosity becomes in the range of 0.5 to 50 Pa·s, to thereby obtain an electroconductive ink.

### Comparative Examples 1 to 8

Except that the prepared composition was changed to each of the compositions shown in Table 1 (numerical value of each component is shown in parts by mass), others were the same as Example 1, and thus, an electroconductive ink was obtained. The binder resins used in the Comparative Example were methyl cellulose which is methyl cellulose 400 manufactured by Wako Pure Industries, Ltd., chitin which is BiNFi-s (using SFo-200) manufactured by Sugino Machine Limited, chitosan which is BiNFi-s (using EFₒ-080) manufactured by Sugino Machine Limited, and poly N-vinylacetamide GE191-103 (PNVA (registered trademark), weight-average molecular weight: 900,000 [catalog value], manufactured by Showa Denko K.K.), prepared into aqueous solution of approximately 10% by mass.

**TABLE 1**

| Component Items | Component Name | | Ex. 1 | COMP. Ex. 1 | COMP. Ex. 2 | COMP. Ex. 3 | COMP. Ex. 4 | COMP. Ex. 5 | COMP. Ex. 6 | COMP. Ex. 7 | COMP. Ex. 8 |
|---|---|---|---|---|---|---|---|---|---|---|---|
| (A) Graphite (parts by mass) | SCMG (Registered Trademark) XR-S | | 100 | 100 | 100 | 100 | 100 | 100 | 100 | 100 | 100 |
| (B) Binder Resin (parts by mass) | (B1) | Methyl Cellulose | | | | | | | 20 | | |
| | | Sodium Carboxymethyl Cellulose | 10 | 20 | 20 | 10 | | | | | |
| | Chitin | | | | | | | | | 20 | |
| | Chitosan | | | | | | | | | | 20 |
| | (B2) | PNVA GE191-053 | 10 | 10 | | | 10 | | | | |
| | | PNVA GE191-103 | | | | | | 10 | | | |
| Binder Resin (Total parts By Mass) | | | 20 | 30 | 20 | 10 | 10 | 10 | 20 | 20 | 20 |
| (B1):(B2) | | | 50:50 | 67:33 | 100:0 | 100:0 | 0:100 | 0:100 | 100:0 | - | - |
| (C) Solvent (parts by mass) | (C1) Water | | 480 | 480 | 480 | 480 | 480 | 480 | 480 | 480 | 480 |
| | (C2) Terpineol | | 10 | 10 | 10 | 10 | 10 | 10 | 10 | 10 | 10 |
| (D) Emulsifier (parts by mass) | LAS | | 0.04 | 0.04 | 0.04 | 0.04 | 0.04 | 0.04 | 0.04 | 0.04 | 0.04 |
| Appearance (Visual) Of Wiring Pattern Shape | | | Good | Good | Good | Good | Good | Good | Good | Poor | Poor |
| Adhesiveness With Substrate | | | Good | Poor | Fair | Good | Fair | Fair | Good | Poor | Poor |
| Volume Resistivity (Ω·cm) | | | 0.59 | 0.73 | 0.43 | 0.53 | 0.73 | 2.11 | 1.99 | O.L. | O.L. |
| Normalized Resistance Value Change Amount | | | 0.03 | 0.05 | 0.05 | 0.03 | | | | | |
| Normalized Resistance Value Change Rate (s⁻¹) | | | 7.6 × 10⁻⁵ | 13 × 10⁻⁵ | 23 × 10⁻⁵ | 15 × 10⁻⁵ | | | | | |

### <Preparation of Carbon Wiring Substrate Using Electroconductive Ink >

Using a semi-automatic screen printer (MT-320, manufactured by Micro-tec Co., Ltd.), a wiring pattern for strain sensitivity measurement was printed on the insulated resin substrate with each of the electroconductive inks obtained by Example 1 and Comparative Examples 1 to 8, and thereby, a carbon wiring substrate is prepared. FIG. 1 shows a shape of the wiring pattern. In FIG. 1, five wiring patterns in the same shape were printed by screen printing in a way so that each of the wiring patterns has a thickness of 40 to 80 µm after being dried. The printed wiring substrate was dried in a box oven under air atmosphere, at 60°C, for 30 minutes, and thereafter, at 100°C, for 30 minutes. The insulated resin substrate used was a polyimide film (Upilex (registered trademark) S25, thickness: 25 µm, manufactured by Ube Industries Ltd.). After the drying, one wiring pattern was cut off to have a shape of 10 mm in width and 150 mm in length, so that the entirety of the wiring pattern extending in the longitudinal direction was included, and an electrode portion (a portion extending in the direction perpendicular to the longitudinal direction) located at the end is partly broken. A sensor terminal for monitoring a change of resistance values by a multimeter (manufactured by Keithley Instrument Corporation), was provided at a resistance measurement position (electrode portion) of the carbon wiring, with a silver paste adhesive agent (SX-ECA48, manufactured by CEMEDINE Co., Ltd.), and thereby, a printed strain sensor was obtained (hereinbelow, may be referred to as carbon wiring substrates of Example 1 and Comparative Examples 1 to 8, respectively, or printed strain sensors of Example 1 and Comparative Examples 1 to 8, respectively).

The judging criteria regarding the appearance (visual) of the wiring pattern shape formed by screen printing of the electroconductive ink are as follows.

Good: No crack nor blur is generated. Printing can be performed without any problems.

Poor: Cracks and blurs are generated.

The adhesiveness between the substrate and the wiring formed by screen-printing of the electroconductive ink is judged in accordance with the judgement criteria below, using a test pattern with an entire-surface print of 20 mm*20 mm, in compliance with JIS K-5-6 Adhesion Test (Cross-cut Test), and on the basis of the classification corresponding to the state how the squares are peeled off.

| | |
|---|---|
| Good: | Classification 0 and 1 |
| Fair: | Classification 2 and 3 |
| Poor: | Classification 4 and 5 |

Evaluation results regarding the wiring pattern shape appearance and the adhesiveness with the substrate are shown in Table 1.

### <Method for Measuring Volume Resistivity of Carbon Wiring Substrate>

A resistance between two points located in the longitudinal direction of the wiring pattern and having 1 cm therebetween was measured by a hand tester (U1242B, manufactured by Agilent Technologies), a film thickness of the wiring pattern was measured by a microscope (VK-X200, manufactured by Keyence Corporation), and a volume resistivity was calculated from the obtained resistance and the film thickness.

### <Method for Measuring Strain Sensitivity of Carbon Wiring Substrate>

The above carbon wiring substrate was set on a precision universal tester (Autograph AG-X, manufactured by Shimadzu Corporation). When the substrate was set, the distance between the chucks was 70 mm, and the substrate was extended at a test speed of 0.5 mm/min until the distance between the chucks reached 70.7 mm, to thereby apply 1% strain in the length direction of the wiring pattern (longitudinal direction of the carbon wiring substrate).

A series of operations including: applying an external force (load) to the carbon wiring substrate to generate 1% strain as above, maintaining the state for 60 seconds, and thereafter, releasing the external force (load) (releasing the strain), was repeated for 10 cycles (hereinbelow, may be referred to as a cycle test). At this time, in order to evaluate a sensitivity regarding dynamic strain, the change of resistance values during the cycle application of the external force (load) was measured by a multimeter (manufactured by Keithley Instrument Corporation) connected to the sensor terminal.

The difference (R₂-R₁₀) between the maximum resistance value (R₂) while the 2nd cycle load was maintained and the minimum resistance value (R₁₀) while the 10th cycle load was maintained, was defined as a cycle resistance value change amount (Ω). Further, the cycle resistance value change amount (Ω) was divided by the resistance value before the strain was generated (initial resistance value: Rₛ), to calculate a normalized resistance value change amount ((R₂-R₁₀)/Rₛ), which was used as a performance index. When the normalized resistance value change amount is 0.05 or less, repeatability regarding the measurement results of the dynamic strain was experimentally considered as favorable, and thus, the strain sensing property was determined as superior.

Further, in order to evaluate a sensitivity regarding static strain, similar to the case of the normalized resistance value change amount, the change of resistance values when the 1% strain was applied and maintained in the length direction of the wiring pattern (longitudinal direction of carbon wiring substrate), was measured. The change amount (R₂ₛ-R₂ₑ) from the resistance value (R₂ₛ) when the 2nd cycle external force (load) started to be maintained, to the resistance value (R₂ₑ) when the maintenance of the external force ended, was divided by the product of the initial resistance value (Rₛ) when the strain is not generated and 60 seconds, i.e., the duration of the external force (load), and thereby, a normalized resistance value change rate ((R₂ₛ-R₂ₑ)/60Rₛ)(s⁻¹) was calculated, which was treated as a performance index. When the normalized resistance value change rate was within ±10×10⁻⁵(s⁻¹), stability regarding the static strain was experimentally considered as favorable (during the strain was applied and maintained, the resistance value change was almost zero), and thus, the strain sensing property was determined as superior.

The measurement results of the normalized resistance value change amount and the normalized resistance value change rate are shown in Table 1.

### Example 1, Comparative Examples 1 to 8 (Study on influences of binder resin composition)

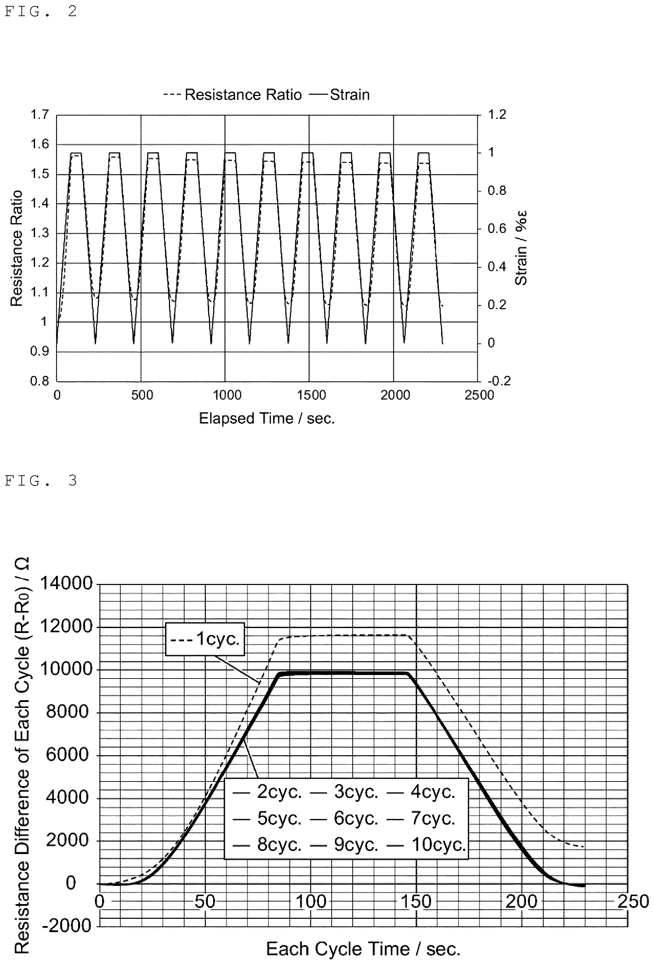

Results of the cycle tests of a printed strain sensor made by the electroconductive ink of Example 1, and provided with 1% strain, are shown in FIG. 2, FIG. 3, and Table 1 (normalized resistance value change amount and normalized resistance value change rate). Results of the cycle tests of the printed strain sensor made by the electroconductives ink of Comparative Examples 1 to 3, and provided with 1% strain, are also shown in Table 1. FIG. 2 shows results of the strain sensitivity measurement (chronological change of resistance and strain) regarding the carbon wiring substrate (printed strain sensor) of Example 1, provided with 1% strain. In FIG. 2, the left vertical axis represents a resistance ratio (ratio between the temporal resistance value after the external force (load) was applied to the carbon wiring substrate, and the initial resistance value before the external force (load) was applied the carbon wiring substrate (shown by the broken line in FIG. 2)), the right vertical axis represents a strain size (%) applied to the carbon wiring substrate (shown by the solid line in FIG. 2), and the horizontal axis represents elapsed time. Further, FIG. 3 shows results of the strain sensitivity measurement (chronological change of resistance of each repeat cycle) regarding the carbon wiring substrate (printed strain sensor) of Example 1, provided with 1% strain. In FIG. 3, the vertical axis represents a resistance difference (difference between a resistance value when the external force (load) was applied to the carbon wiring substrate, and a resistance value when the external force (load) was released) of each cycle, and the horizontal axis represents time required for each cycle.

The results shown in FIG. 2 and FIG. 3 reveal that regarding the carbon wiring substrate (printed strain sensor) of Example 1, the normalized resistance value change amount was 0.03, and thus, repeatability for the dynamic strain is sufficiently high. Also, the results reveal that the normalized resistance value change rate was 7.6×10⁻⁵(s⁻¹), and thus, repeatability for the static strain is also sufficiently high. In addition, the resistance value change behavior against the strain is highly linear. As shown in FIG. 3, while a strain was gradually increased at a constant rate, and while a strain was gradually decreased at a constant rate, the resistance values constantly changed (the slopes are linear). On the other hand, when the binder resins of Comparative Examples 1 to 3 were used, the normalized resistance value change amounts were 0.03 or more, and the normalized resistance value change rates exceeded 7.6×10⁻⁵(s⁻¹), that is, both properties were deteriorated. When the binders of Comparative Examples 4 to 8 were used, there were drawbacks that the wiring pattern had a high volume resistivity, the adhesion between the wiring pattern and the substrate was rather inferior, and the like, and thus, cycle tests were not performed.

### Examples 1 to 3, Comparative Examples 9 to 13 (Study on influences of amount, mixing ratio of binder resins)

According to the compositions shown in Table 2 (numerical values of each component refer the values of parts by mass), the components were mixed to obtain electroconductive inks. Example 1 is the same as the one shown in Table 1. Using the electroconductive inks obtained as above, the cases containing both sodium carboxymethyl cellulose and poly N-vinylacetamide, which had preferable results regarding both of the dynamic strain and the static strain as shown in Table 1, were studied with respect to the influences of the addition amount, mixing ratio of the binder resin. The results are shown in Table 2. The evaluation method was the same as that of the above-mentioned Example 1. As in Example 2 where the additive amount of the binder resin was smaller than that of Example 1, both the normalized resistance value change amount and the normalized resistance value change rate were improved. However, in view of the adhesiveness to the substrate and flexibility relating to handiness, reduction of the additive amount was limited. On the other hand, when the binder resin additive amount was larger than Example 1 (Comparative Examples 9 to 12), both the normalized resistance value change amount and the normalized resistance value change rate gradually deteriorated. Example 3 where a content of the sodium carboxymethyl cellulose corresponded to 75% of the binder resin had an absolute value of the normalized resistance value change rate slightly higher (a little less than 7%) than that of Example 1 where the content was 50%, whereas Comparative Example 13 where the content was 25% had an absolute value of the normalized resistance value change rate 40% or more higher than that of Example 1. When the binder of Comparative Example 12 was used, there were drawbacks that the volume resistivity of the wiring pattern was too high to follow the change of the resistance values, or the adhesion between the wiring pattern and the substrate was extremely poor, or the like, and thus, the cycle test was not performed for Example 12.

**TABLE 2**

| Component Items | Component Name | Ex. 1 | Ex. 2 | Ex. 3 | COMP. Ex. 9 | COMP. Ex. 10 | COMP. Ex. 11 | COMP. Ex. 12 | COMP. Ex. 13 |
|---|---|---|---|---|---|---|---|---|---|
| (A) Graphite (parts by mass) | SCMG (Registered Trademark) XR-S | 100 | 100 | 100 | 100 | 100 | 100 | 100 | 100 |
| (B) Binder Resin (parts by mass) | (B1) Sodium Carboxymethyl Cellulose | 10 | 5.6 | 15 | 12.5 | 21.4 | 33.3 | 50 | 5 |
| | (B2) PNVA GE191-053 | 10 | 5.6 | 5 | 12.5 | 21.4 | 33.3 | 50 | 15 |
| Binder Resin (Total parts By Mass) | | 20 | 11.2 | 20 | 25 | 42.8 | 66.6 | 100 | 20 |
| (B1):(B2) | | 50:50 | 50:50 | 75:25 | 50:50 | 50:50 | 50:50 | 50:50 | 25:75 |
| (C) Solvent (parts by mass) | (C1) Water | 480 | 267 | 480 | 600 | 1029 | 1600 | 2400 | 480 |
| | (C2) Terpineol | 10 | 10 | 10 | 10 | 10 | 10 | 10 | 10 |
| (D) Emulsifier (parts by mass) | LAS | 0.04 | 0.04 | 0.04 | 0.04 | 0.04 | 0.04 | 0.04 | 0.04 |
| Appearance (Visual) Of Wiring Pattern Shape | | Good | Good | Good | Good | Good | Good | Good | Good |
| Adhesiveness With Substrate | | Good | Good | Good | Good | Good | Fair | Poor | Good |
| Volume Resistivity (Ω·cm) | | 0.59 | 0.34 | | 0.41 | 1.37 | 7.23 | O.L. | |
| Normalized Resistance Value Change Amount | | 0.03 | 0.02 | 0.03 | 0.05 | 0.08 | 0.1 | | 0.04 |
| Normalized Resistance Value Change Rate (s⁻¹) | | 7.6 × 10⁻⁵ | 1.6 × 10⁻⁵ | -8.1 × 10⁻⁵ | -21 × 10⁻⁵ | 14 × 10⁻⁵ | -62 × 10⁻⁵ | | -10.8 × 10⁻⁵ |

### Examples 4, 5 (Study on influences of resin film laminate)

Using each of the electroconductive inks having a mixing ratio shown in Table 3, and containing a 1:1 (mass ratio) mixture of sodium carboxymethyl cellulose and poly N-vinylacetamide as a binder, a carbon wiring (wiring pattern) of 30 to 50 µm thick was formed on a polyimide film to form a carbon wiring substrate, and the carbon wiring substrate was laminated with a resin film to obtain a strain sensor. The results of moisture resistance evaluation of the strain sensors are shown in Table 3. Here, the evaluation methods for the normalized resistance value change amount and normalized resistance value change rate were the same as those of Example 1 mentioned above.

In order to increase the adhesiveness between the resin film and the polyimide film, the polyimide film was, in advance, immersed in a sodium hydroxide aqueous solution of 4% by mass for 1 minute, thereafter, washed with distilled water, and then, the moisture was removed.

The wiring pattern was printed, in the same way as Example 1, on the polyimide film subjected to the above treatment, and dried. The obtained printed/dried product was placed between two resin films and laminated, to thereby obtain a carbon wiring substrate. For laminating, a laminator (L405A3, set temperature: 140°C, feed rate: approximately 11 mm/second, manufactured by ASKA Corporation) was used. Before the laminating, an opening was previously formed on the resin film at a position corresponding to the resistance measurement position of the carbon wiring. Lamination was performed while the opening was aligned with the resistance measurement position of the wiring. The exposed resistance measurement position of the carbon wiring was provided with a terminal using a silver paste adhesive agent (SX-ECA48, manufactured by CEMEDINE Co., Ltd.) for monitoring a change of resistance values by a multimeter (manufactured by Keithley Instrument Corporation), to thereby obtain a printed strain sensor.

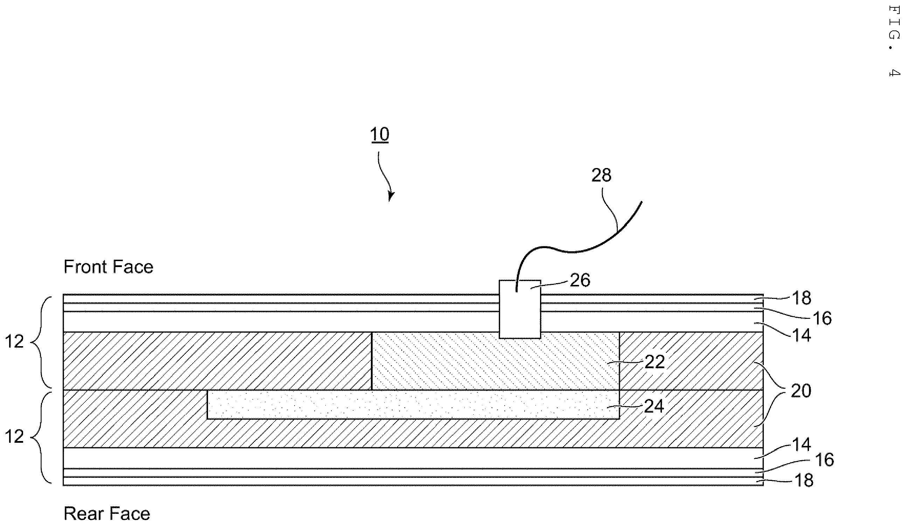

In Example 4, a resin film 12 included, as a part thereof, TECHBARRIER (registered trademark) LS (manufactured by Mitsubishi Chemical Corporation) which comprises a PET film 14 with a thickness of 12 µm provided on one main face thereof with a silica-deposited film 16 with a thickness of 1µm or less, and a protection layer 18 with a thickness of 1 µm or less formed thereon. The resin film 12 also includes a low density polyethylene (LLDPE) layer 20 with a thickness of 50 µm provided on the other main face of the PET film 14. The polyimide film 24 on which the wiring pattern 22 was formed, was arranged between the resin films 12, in a way so that each of the low density polyethylene (LLDPE) layers 20 of the resin films 12 faced the polyimide film 24. Further, the wiring pattern 22 was provided with a terminal 26 at a position aligned with the opening, and the terminal 26 was provided with a covered wire 28 for connecting to the multimeter (manufactured by Keithley Instrument Corporation). FIG. 4 shows a structure of the strain sensor according to Example 4.

In Example 5, a polyethylene film with a thickness of 20 µm was used in place of the PET film 14 in Example 4 (FIG. 4), an aluminum foil with a thickness of 15 µm was used in place of the silica-deposited film 16, and a PET film with a thickness of 12 µm was used, by being placed thereon, in place of the protection layer 18. Further, a hot-melt adhesive agent layer with a thickness of appropriately 18 µm was used in place of the low density polyethylene (LLDPE) layer 20. The polyimide film 24 was arranged between the resin films 12, so that each of the hot-melt adhesive agent layers faced the polyimide film 24.

The carbon wiring substrates of Example 1, 4, and 5 were placed under an atmosphere at a temperature of 20°C, a relative humidity of 50% RH, for 20 minutes; and under an atmosphere at a temperature of 20°C, a relative humidity of 90% RH, for 20 minutes. Using the change amount of resistance values between before and after the placement for 20 minutes, a resistance value change amount per minute was calculated. The calculation results are shown in Table 3.

Regarding Example 4 where the SiO₂ (silica) deposited film was used for lamination, all of the normalized resistance value change amount, the normalized resistance value change rate, and the linearity of the resistance value change behavior against the strain showed superior performance as the one without the lamination (Example 1). On the other hand, regarding Example 5 where the resin film provided with the aluminum foil was used for lamination, although the normalized resistance value change amount did not largely change, the absolute value of the normalized resistance value change rate was larger (that is, deteriorated) compared to that of Example 4.

When the sensor formed by using a 1:1 (mass ratio) mixture of sodium carboxymethyl cellulose and poly N-vinylacetamide as a binder resin, and being laminated with the resin films (Example 4, 5) was left still in a high-temperature high-humidity environment, the resistance value increase rate (Ω/min) was very small. On the other hand, when the sensor without the lamination (Example 1) was left still in the same environment, the resistance value increase rate (Ω/min) was raised (in particular, under an atmosphere at a temperature of 20°C and a relative humidity of 90% RH). Accordingly, this revealed that covering the carbon wiring with resin films increases moisture resistant property, and thus, achieving a superior environment resistance can be expected.

**TABLE 3**

| Component Items | Component Name | Ex. 1 | Ex. 4 | Ex. 5 |
|---|---|---|---|---|
| (A) Graphite (parts by mass) | SCMG (Registered Trademark) XR-S | 100 | 100 | 100 |
| (B) Binder Resin (parts by mass) | (B1) Sodium Carboxymethyl Cellulose | 10 | 10 | 10 |
| | (B2) PNVA GE191-053 | 10 | 10 | 10 |
| Binder Resin (Total parts By Mass) | | 20 | 20 | 20 |
| (B1):(B2) | | 50:50 | 50:50 | 50:50 |
| (C) Solvent (parts by mass) | (C1) Water | 480 | 480 | 480 |
| | (C2) Terpineol | 10 | 10 | 10 |
| (D) Emulsifier (parts by mass) | LAS | 0.04 | 0.04 | 0.04 |
| Laminate | Silica-deposited PET | | With Lamination | |
| | Al foil PET | | | With Lamination |
| Normalized Resistance Value Change Amount | | 0.03 | 0.03 | 0.03 |
| Normalized Resistance Value Change Rate (s⁻¹) | | 7.6 × 10⁻⁵ | -8.8 × 10⁻⁵ | 10 × 10⁻⁵ |
| Resistance Value Increase Rate (Ω/min) | 20°C, 50% RH | 2 | < 1 | < 1 |
| | 20°C, 90% RH | 63 | 1 | < 1 |

### Example 6 to 8 (Study on influences of strain)

As Example 6, except that the test speed was 0.5 mm/min, the extension was performed until the distance between the chucks became 73.5 mm, and applied strain was 5% strain, operations (cycle test) were the same as those of Example 1, and the normalized resistance value change amount and the normalized resistance value change rate when the 5% strain was applied, were calculated. As Example 7, except that the test speed was 0.5 mm/min, the extension was performed until the distance between the chucks became 77 mm, and applied strain was 10% strain, operations (cycle test) were the same as those of Example 1, and the normalized resistance value change amount and the normalized resistance value change rate were calculated. As Example 8, except that the test speed was 0.5 mm/min, the extension was performed until the distance between the chucks became 73.5 mm, and applied strain was 5% strain, operations (cycle test) were the same as those of Example 4, and the normalized resistance value change amount and the normalized resistance value change rate when the 5% strain was applied, were calculated.

In Example 6, the normalized resistance value change amount was 0.34, and the normalized resistance value change rate was 84×10⁻⁵(s⁻¹)). In Example 7, the normalized resistance value change amount was 0.52, and the normalized resistance value change rate was 254×10⁻⁵(s⁻¹). In Example 8, the normalized resistance value change amount was 0.26, and the normalized resistance value change rate was 131×10⁻⁵(s⁻¹)). Both of the normalized resistance value change amount and the normalized resistance value change rate tended to gradually increase as the applied strain increased. However, none of Examples 6 to 8 showed drawbacks such that the wiring was broken, and the resistance value measurement (strain sensing) could be repeated.

### Explanation of Numerals

10 strain sensor, 12 resin film, 14 PET film, 16 silica-deposited film, 18 protection layer, 20 low density polyethylene (LLDPE) layer, 22 wiring pattern, 24 polyimide film, 26 terminal (silver past adhesive agent), 28 covered wiring

## Claims

1. An electroconductive ink comprising: a carbonaceous electroconductive material (A), a binder resin (B) containing a cellulose compound (B1) and a poly N-vinyl compound (B2), and a solvent (C),
wherein a content of binder resin (B) is 0.5 to 23 parts by mass relative to 100 parts by mass of (A) carbonaceous electroconductive material,
a mixing ratio by mass of the cellulose compound (B1) and the poly N-vinyl compound (B2) is 80:20 to 40:60, and
the solvent (C) contains water (C1).

2. An electroconductive ink according to claim 1, wherein cellulose compound (B1) is sodium carboxymethyl cellulose, and the poly N-vinyl compound (B2) is poly N-vinylacetamide.

3. An electroconductive ink according to claim 1 or claim 2, wherein the carbonaceous electroconductive material (A) is graphite powder having an average particle diameter of 25 µm or less.

4. A carbon wiring substrate comprising an insulated substrate having thereon a wiring pattern printed by using an electroconductive ink,
the electroconductive ink comprising a carbonaceous electroconductive material (A), a binder resin (B) containing a cellulose compound (B1) and a poly N-vinyl compound (B2), and a solvent (C),
a content of binder resin (B) being 0.5 to 23 parts by mass relative to 100 parts by mass of (A) carbonaceous electroconductive material,
a mixing ratio by mass of the cellulose compound (B1) and the poly N-vinyl compound (B2) being 80:20 to 40:60, and
the solvent (C) containing water (C1).

5. A carbon wiring substrate with a wiring pattern which comprises a carbonaceous electroconductive material (A), and a binder resin (B) containing a cellulose compound (B1) and a poly N-vinyl compound (B2)
wherein a content of binder resin (B) is 0.5 to 23 parts by mass relative to 100 parts by mass of (A) carbonaceous electroconductive material, and
a mixing ratio by mass of the cellulose compound (B1) and the poly N-vinyl compound (B2) is 80:20 to 40:60.

6. A carbon wiring substrate according to claim 4 or claim 5, wherein the wiring pattern is covered with a resin film.

7. A carbon wiring substrate according to claim 6, wherein the resin film comprises a silica film.
